(19)

Europäisches
Patentamt
European
Patent Office
Office européen
des brevets

(11) **EP 4 675 869 A1**

(12) **EUROPEAN PATENT APPLICATION**

(43) Date of publication:
**07.01.2026 Bulletin 2026/02**

(21) Application number: **24186605.2**

(22) Date of filing: **04.07.2024**

(51) International Patent Classification (IPC):
*H01S 5/00* (2006.01)   *G01J 3/26* (2006.01)
*G01J 3/28* (2006.01)   *G01J 3/02* (2006.01)

(52) Cooperative Patent Classification (CPC):
**G01J 3/28; G01J 3/26; H01S 5/0014;** G01J 3/0218;
H01S 5/0617

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Luna Innovations Incorporated
Roanoke, VA 24011 (US)**

(72) Inventors:
• **KOMINSKY, Daniel
  Pilot, 24138 (US)**
• **SAUERS, Kevin
  Hudson, 01749 (US)**
• **YAFFE, Henry
  Reisterstown, 21136 (US)**

(74) Representative: **D Young & Co LLP
3 Noble Street
London EC2V 7BQ (GB)**

(54) **METHOD AND APPARATUS FOR PERFORMING LASER SPECTRUM TESTING OF FABRICATED LASERS AT HIGH SPEED**

(57)   An apparatus determines one or more spectral characteristics of an optical device under test (DUT) and includes at least one tunable optical filter configured to receive an input DUT signal, data acquisition hardware to detect DUT output signals from the at least one tunable optical filter based on the input DUT signal, and processing circuitry coupled to the data acquisition hardware. The processing circuitry applies a control signal over a calibration range of values to the at least one tunable optical filter to generate a calibration signal and uses the calibration signal to determine a calibration function to separate a spectral response of the at least on tunable optical filter from a spectral content of the input DUT signal. The processing circuitry then applies the control signal over a measurement range of values corresponding to a spectral region of interest to the at least one tunable optical filter to generate DUT measurement samples. The calibration function is used to process the DUT measurement samples to separate a spectral transfer function response of the at least one tunable optical filter to the applied control signal from a DUT response to the applied control signal. The processing circuitry extracts one or more spectral characteristics from the DUT response for evaluation.

Fig. 1

EP 4 675 869 A1

**Description**

INTRODUCTION

In general, optical device manufacturers need a mechanism by which they can perform quality assurance on the optical devices that they fabricate. For example, laser manufacturers need a mechanism by which they can perform quality assurance on the lasers that they fabricate. A particular area of interest is the semiconductor laser industry where many semiconductor lasers are simultaneously produced on a single semiconductor wafer, and they need to be characterized.

Each semiconductor chip device needs to be tested for performance under many (e.g., hundreds of) different combinations of voltages and currents. Because there are many (e.g., hundreds of) devices on a single wafer, high speed and/or highly parallelized testing of the devices on the wafer is desirable for a fabrication/production environment. Using semiconductor lasers as an example, one example test measurement for each laser is side mode suppression ratio (SMSR), which is a measure of how much light a given laser is emitting at a wavelength other than the one at which the laser is designed to operate. A laser with insufficient SMSR emits light at a wavelength that is outside its allocated section of the spectrum, resulting in crosstalk with other channels that may occupy the same optical fiber. Other example test measurements for each laser include laser center wavelength which is the actual wavelength of the primary emission of the laser is emitting, total power emitted from the laser, side mode(s) wavelength(s) and power(s), and/or others.

Thus, it would be desirable to have a method and apparatus for performing spectrum testing of fabricated optical devices at high speed.

It would also be desirable to perform high-speed spectrum testing of fabricated optical devices using a relatively low-cost apparatus.

It would also be desirable to perform measurements with high spectral resolution over a broad range of potential input wavelengths.

Another desirable goal is for the high-speed spectrum testing apparatus to be self-calibrating (not requiring the input of a known spectrum) and to calibrate just once per device to be tested.

Another desirable goal is for the high-speed spectrum testing method and apparatus to continue to function properly in situations where optical characteristics of the testing apparatus change over time.

SUMMARY

In certain example embodiments, an apparatus determines one or more spectral characteristics of an optical device under test (DUT). At least one tunable optical filter is configured to receive an input DUT signal, and data acquisition hardware is configured to detect DUT output signals from the at least one tunable optical filter based on the input DUT signal. Processing circuitry, coupled to the data acquisition hardware, is configured to apply a control signal over a calibration range of values to the at least one tunable optical filter to generate a calibration signal. The calibration signal is used to determine a calibration function to separate a spectral response of the at least one tunable optical filter from a spectral content of the input DUT signal. The processing circuitry is configured to apply the control signal over a measurement range of values corresponding to a spectral region of interest to the at least one tunable optical filter to generate DUT measurement samples. The calibration function is used to process the DUT measurement samples to separate a spectral transfer function response of the at least one tunable optical filter to the applied control signal from a DUT response to the applied control signal. The processing circuitry is configured to extract one or more spectral characteristics from the DUT response for evaluation.

In some example embodiments, each tunable optical filter the apparatus has a spectral transfer function that is adjustable based on a control signal and configured to receive a DUT input spectrum in a desired wavelength range and to output a DUT output spectrum corresponding to a modified version of the DUT input spectrum. The spectral transfer function has two or more peak transmission wavelengths with a spectral separation corresponding to a free spectral range (FSR) of the tunable optical filter. The processing circuitry is configured, in a calibration stage, to determine the calibration range of values and apply the control signal over the calibration range of values to each tunable optical filter, where each tunable optical filter is configured to modify the DUT input spectrum to generate calibration samples. The calibration function includes a deconvolution vector that is based on the calibration samples. In a DUT measurement stage, the processing circuitry is configured to apply the control signal over a range of values corresponding to a spectral region of interest to each tunable optical filter to generate DUT measurement samples; apply the deconvolution vector to the DUT measurement samples to generate the DUT response having a reconstructed DUT input spectrum; and extract one or more spectral characteristics from the reconstructed DUT spectrum for evaluation.

In some example implementations, the DUT is a laser and the one or more spectral characteristics including one or more of the following: a side mode suppression ratio (SMSR), center wavelength power, peak width, one or more side mode wavelengths, and one or more sidemode powers.

In some example embodiments, the processing circuitry is configured to determine whether the reconstructed DUT spectrum satisfies one or more specified performance requirements based on the one or more extracted spectral characteristics.

In some example implementations, an optical device generates an input reference spectrum for characterizing the spectral transfer function of the at least one tunable optical filter, and optical detectors detect light output from each tunable optical filter and generate the DUT measurement samples and reference output samples which are provided to the processing circuitry. At least some of the DUT measurement samples and the reference output samples may have nonuniform spectral spacing. The processing circuitry, in at least one of the calibration stage and the DUT measurement stage, is configured to process the reference output samples having nonuniform spectral spacing to detect reference spectrum features, and based on the detected reference spectrum features, resample the DUT measurement samples to uniform spacing in wavelength or optical frequency thereby correcting for nonlinearity in one or more of: the spectral transfer function of the at least one tunable optical filter, the control signal, and a response of the at least one tunable optical filter to the control signal.

In some example implementations, the input reference spectrum is in a wavelength band that is out of band from the wavelength band of operation of the DUT, and the apparatus may further include: a source with a broadband spectrum of light; an athermal optical device configured to receive the broadband spectrum of light and generate a modified broadband spectrum of light with known features at known wavelengths or at constant wavelength increments; and a bandpass filter, having a passband approximately corresponding to a width of the FSR of at least one tunable optical filter, configured to receive the modified broadband spectrum and provide the reference spectrum. Each tunable optical filter may be a Fabry-Perot (FP) tunable optical filter operable based on interference and resonance within an optical cavity and the reference spectrum provides information of an instantaneous size of a cavity of the FP tunable optical filter. Based on an associated time and cavity sizes for each reference spectral feature, the processing circuitry is configured to resample the DUT measurement samples to uniform spacing in wavelength or optical frequency so that the reference spectral features align in time with desired intervals in the spectrum.

In some example embodiments, the processing circuitry is configured, in the calibration stage, to: apply the control signal over the range of values to each tunable optical filter to generate the reference spectrum; determine a location of a main spectral peak in the DUT measurement samples relative to the reference spectrum; determine a limited range of control signal values based on the location of the main spectral peak; and apply the control signal over the limited range of control signal values to determine a calibration range of values based on the location of the main spectral peak relative to the reference spectrum to correct for wavelength dependent variations in system responsivity.

In some example implementations, the processing circuitry is configured, in the calibration stage, to: correlate the main spectral peak to an ideal spectral shape of an expected spectral transfer function of the at least one tunable optical filter and determine an expected response to an ideal DUT input spectrum; and generate the deconvolution vector based on the expected spectral transfer function of the at least one tunable optical filter and the ideal DUT input spectrum.

In some example embodiments, the apparatus may further include a known optical source having a known optical input spectrum and where the known optical source can be used as a DUT. The processing circuitry is configured, in the calibration stage, to: measure the DUT output spectrum of the known optical source, correlate the DUT output spectrum of the known optical source to a known spectral shape of the known optical source; and generate the deconvolution vector based on the DUT output spectrum and the known optical input spectrum. The processing circuitry is configured, in the DUT measurement stage, to: based on the known optical input spectrum, resample the DUT measurement samples to uniform spacing in wavelength or optical frequency to generate resampled DUT measurement samples, and apply the deconvolution vector to the resampled DUT measurement samples to generate the DUT response to the applied control signal. The processing circuitry may be further configured, in the DUT measurement stage, to: determine a primary spectral peak in the reconstructed DUT input spectrum which corresponds to a DUT center wavelength, and determine whether the one or more spectral characteristics fails to meet one or more predetermined parameters.

In some example embodiments, the apparatus may include a first tunable optical filter and a second tunable optical filter. A first FSR of the first tunable optical filter is larger than a second FSR of the second tunable optical filter. A location of a first main spectral peak of the first tunable optical filter and a location of a second main spectral peak of the second tunable optical filter are used to uniquely identify the one or more spectral characteristics of the DUT.

Some example embodiments include method for determining one or more spectral characteristics of an optical device under test (DUT). At least one tunable optical filter receives an input DUT signal and DUT output signals from the at least one tunable optical filter are detected based on the input DUT signal. A control signal is applied over a calibration range of values to the at least one tunable optical filter to generate a calibration signal. The calibration signal is used to determine a calibration function to separate a spectral response of the at least one tunable optical filter from a spectral content of the input DUT signal. The control signal over a measurement range of values corresponding to a spectral region of interest is applied to the at least one tunable optical filter to generate DUT measurement samples. The calibration function to the DUT measurement samples is applied to separate a spectral transfer function of the at least one tunable optical filter from a DUT response to the applied control signal. One or more spectral characteristics is extracted from the DUT response for evaluation.

This Summary is provided to introduce a selection of concepts that are further described below in the Detailed Description. This Summary is intended neither to identify key features or essential features of the claimed subject matter, nor to be used to limit the scope of the claimed subject matter; rather, this Summary is intended to provide an overview of the subject matter described in this document. Accordingly, it will be appreciated that the above-described features are merely examples, and that other features, aspects, and advantages of the subject matter described herein will become apparent from the following Detailed Description, Figures, and Claims.

BRIEF DESCRIPTION OF THE FIGURES

These and other features and advantages will be better and more completely understood by referring to the following detailed description of example non-limiting illustrative embodiments in conjunction with the drawings. Unless specific dimensions are given in a figure, the figures are not necessarily to scale and are schematic representations.

Figure 1 shows an example embodiment of a high-speed, self-calibrating spectrum testing apparatus for measuring output spectral characteristics of a DUT.

Figure 2 shows example spectral graphs A-D for the tunable filter and DUT associated with the apparatus in the example embodiment of Figure 1 including showing how the spectral response of the tunable filter modifies the input DUT spectrum to create a measured response.

Figures 3A and 3B show example spectral graphs for generating a deconvolution vector for calibrating the measured DUT spectrum.

Figure 4 shows example spectral graphs for reconstructing the DUT spectrum using a deconvolution vector.

Figure 5 is a flowchart diagram showing example procedures for both an arming/calibration process and an example DUT spectrum measurement process.

Figure 6 is a flowchart diagram showing example procedures for generating a deconvolution vector as part of the calibration stage.

Figure 7 is a flowchart diagram showing example procedures for a DUT spectrum measurement process as a part of a measurement stage.

Figure 8 shows an example of a reconstructed DUT spectrum including a center wavelength and sidemodes.

Figure 9 shows another example embodiment of a high-speed, self-calibrating spectrum testing apparatus for measuring output spectral characteristics of a DUT.

Figure 10A shows an example broadband source spectrum; Figure 10B shows an example reference spectral response output in which the broadband source spectrum in 10A has been modified by the response from a stable optical element 52 in Figure 9 and from the bandpass filter 54 in Figure 9; Figure 10C shows an example spectral response of the tunable filter (bold) showing two adjacent orders of the tunable filter superimposed on the reference spectrum of Figure 10B; and Figure 10D is an example measured spectral response of the filter to the reference spectrum

Figures 11A and 11C show example graphs illustrating nonlinear and ideal responses for a tunable filter, respectively, and Figures 11B and 11D show example graphs of an example measured response of the tunable filter with both a DUT output and a reference output for the nonlinear and ideal cases, respectively.

Figure 12 is a flowchart diagram showing example resampling procedures for use in the calibration stage and the measurement stage.

Figure 13 shows an example measured response of the tunable filter with the DUT and reference output spectra illustrating selection of a narrower tuning or "armed" sweep range for the tunable filter as part of the tunable filter calibration stage using the example embodiment of Figure 9.

Figure 14 is a flowchart diagram showing example procedures for an example arming/calibration process for the apparatus in the example embodiment of Figure 9.

Figure 15 shows another example embodiment of a high-speed, self-calibrating spectrum testing apparatus for measuring output spectral characteristics of a DUT.

Figure 16 is a graph illustrating example spectral response of two tunable filters with different FSRs shown in the example embodiment of Figure 15 and the separation of an overall calibration into multiple calibration subsets.

Figure 17 shows an example measured filter response of a coarser tunable filter and a finer tunable filter with the DUT and reference output spectrums as part of the calibration stage using the example embodiment of Figure 15.

Figure 18 shows another example embodiment of a high-speed, self-calibrating spectrum testing apparatus for measuring output spectral characteristics of a DUT.

DETAILED DESCRIPTION OF EXAMPLE EMBODIMENTS

Specific embodiments are shown by way of example in the drawings and will herein be described in detail. It should be understood, however, that the drawings and detailed description are not intended to limit the claims to the particular embodiments disclosed, even where only a single embodiment is described with respect to a particular feature. On the contrary, the intention is to cover all modifications, equivalents and alternatives that would be apparent to a person skilled in the art having the benefit of this disclosure. Examples of features provided in the disclosure are intended to be illustrative rather than restrictive unless stated otherwise.

Terms, such as first, second, and the like, may be used herein to describe various components. Each of these terminologies is not used to define an essence, order or sequence of a corresponding component but used merely to distinguish the corresponding component from other component(s). For example, a "first" component may be referred to as a "second" component, and similarly, the "second" component may be referred to as the "first" component. "Based on" as used herein covers based at least on. As used throughout this application, the word "may" is used in a permissive sense (i.e., meaning having the potential to), rather than the mandatory sense (i.e., meaning must). The singular forms "a", "an", and "the" are intended to include the plural forms as well, unless the context clearly indicates otherwise. It will be further understood that the terms "comprises/comprising" and/or "includes/including" when used herein, specify the presence of stated features, steps, operations, elements, and/or components, but do not preclude the presence or addition of one or more other features, integers, steps, operations, elements, components and/or groups thereof.

The same name may be used to describe an element included in the embodiments described above and an element having a common function. Once a component or function is described for one embodiment, that description is not repeated for other embodiments where that component or function operates or performs similarly. Unless disclosed to the contrary, a configuration of components disclosed in any embodiment may be applied to other embodiments, and the specific description of the repeated configuration will be omitted.

Unless otherwise defined, all terms used herein including technical or scientific terms have the same meaning as commonly understood by one of ordinary skill in the art to which an example belongs. Terms, such as those defined in commonly used dictionaries, are to be interpreted as having a meaning that is consistent with their meaning in the context of the relevant art and are not to be interpreted in an idealized or overly formal sense unless expressly so defined herein.

The following definitions are provided for some terms used in this application.

Side Mode Suppression Ratio (SMSR) denotes how much light is emitted at any given wavelength other than the design wavelength relative to the amount of light which is emitted at the design wavelength. Typically, SMSR is measured in dB (decibels). For example, a SMSR of 30dB means that a given side mode is emitting 0.1% as much optical power as the emission at the design wavelength of the laser.

Optical power (absolute) is expressed in mW (milliwatts) or dBm (decibel milliwatts).

Optical power (relative) defines a relationship between the amount of power in two signals and can be expressed as a percentage or in dB.

Side mode bands or SMSR mask for a given laser denote a range of wavelengths relative to the central laser peak that are of interest, e.g., side modes between 0.2 and 1.5nm from the primary peak might be of interest.

Fabry-Perot (FP) interferometer : a type of interferometer created by having colinear reflectors.

Tunable filter (TF): an optical filter that selectively transmits (passes) light in a particular range of wavelengths while reflecting, absorbing, or attenuating remaining wavelengths. Tunable means that the central wavelength in the transmitted range of wavelengths is selectable. A tunable filter may have multiple orders of transmission peaks which are separated by the free spectral range of the filter.

Fiber Fabry-Perot Tunable Filter (FFP-TF): a tunable optical filter using a FP interferometer.

Convolution: a physical or mathematical process by which two signals are combined to form a new signal. A mathematical definition of a convolution of two signals $f(x)$, $g(x)$ is given by the equation: $(f * g)(y) = \int f(x)g(y - x)dx$.

Deconvolution: a mathematical process by which an input signal can be recovered from the output of a convolution based on knowledge about the other input signal.

Wavelength division multiplexing (WDM) combines or splits light with different wavelengths into a single path. WDM is also used as the name of the device that performs the WDM function.

Semiconductor optical amplifier (SOA).

Athermal Fabry-Perot Interferometer (AFPI).

ASE: Amplified spontaneous emission. The incoherent output of an SOA which does not have a seed signal injected into it. This produces a broadband spectrum over the entire gain range of the medium.

Termination: a feature or device on the end of an optical fiber that prevents reflections.

Device under test (DUT)

Free Spectral Range (FSR): denotes how far apart in optical frequency (or wavelength) adjacent orders of an optical filter are, which corresponds to the distance between the transmitted (passed) transmission peaks.

Terahertz (THz): measure of optical frequency, equivalent to the speed of light divided by the wavelength (in vacuum). At 1310 nm (~228.8 THz absolute): a difference of 1THz ~5.7nm; at 1550nm (~193.4 THz absolute): a difference of 1THz ~ 8nm

Order of a filter: denotes which of various transmission peaks passed by a filter is being considered. Two peaks which are one FSR apart are said to be separated by one order.

Lorentzian or Lorentzian Function: the shape of the spectral response of a single order of a FP filter.

Airy Function: the repeating sequence of Lorentzian pulses that represent the true response of a FP filter.

Finesse: a measure of the difference between the highest and lowest amounts of transmission through a filter.

O-band: The range of wavelengths from 1260nm to 1360nm.

S-band: The range of wavelengths from 1460nm to 1530nm.

C-band: The range of wavelengths from 1530nm to 1565nm.

Bandpass filter: an optical device that allows light from a subset of wavelengths to be transmitted and substantially attenuating or blocking all others.

Isolator: An optical device that only allows light to propagate through it in one direction.

Coupler (or "splitter"): a passive optical device that takes light from some number of input fibers and distributes it among some number of output fibers. The ratio of power to the various output fibers may be equal or not.

Switch: An optical switch is an active device that selectively directs light from some number of inputs to some number of outputs based on the application of a control signal.

PD: Photodetector.

PZT: Piezo-electric transducer which is one example driving component for optical TFs.

Reference spectrum: the use of light in a different band than that of the DUT to monitor the gap, and thus the spectral response, of a tunable filter TF.

Page: when two TFs are used in certain example embodiments, a finer TF with a smaller free spectral range (FSR) than a coarser TF with a larger FSR, a different calibration subset is performed for each order of the finer TF. Each calibration subset for one order of the TF is referred to as a page. The response of the coarser TF is used to select which page is the appropriate one for use with the finer TF.

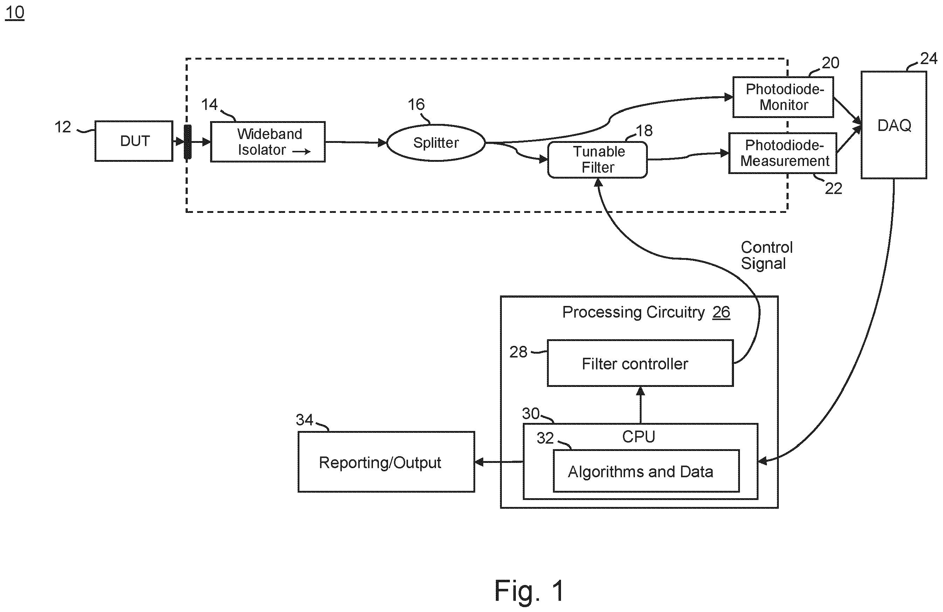

Figure 1 shows an example embodiment of a high-speed, self-calibrating spectrum testing apparatus 10 for measuring one or more spectral characteristics of an optical DUT 12 such as a laser. Input light from the DUT 12 propagates in one direction through a wide band isolator 14 and is then split in optical splitter 16. Some of the input light is input to a tunable optical filter 18, and then to measurement photodiode 22, and another amount is provided to a monitor photodiode detector (PD-mon) 20. The monitor PD 20 is used to determine the amount of power which is being input to the system by the DUT and to verify that the power input from the DUT is stable during the measurement process. Processing circuitry 26 includes a filter controller 28 and one or more central processing units (CPUs) 30 that includes processing circuitry as well as memory 32, where the memory 32 stores computer program implemented processing algorithms and various types of data. The CPU 30 provides control commands for the filter controller 28 to generate a changing control signal for scanning or tuning the tunable optical filter 18 over a range of wavelengths. The spectral response output from the tunable optical filter 18 is detected in a measurement photodiode detector (PD) 22. The optical signals detected by the monitor PD 20 and the measurement PD 22 are output as corresponding analog electrical signals to data acquisition circuitry (DAQ) 24 that includes an analog to digital converter (ADC) which converts the analog electrical signals into digital electrical samples. The output from the monitor PD 20 is used by the processing circuitry 26 to monitor the DUT input power. For example, unstable DUT power yields inaccurate results. The DAQ 24 provides the digital samples to the CPU 30 for processing. Based on the processing, the CPU 30 outputs 34 one or more characteristics, parameters, and/or test results for the DUT 12.

In a calibration stage, the processing circuitry 26 applies a changing control signal over a calibration range of values to the tunable optical filter 18 which outputs a calibration spectrum that is used to determine a calibration function to separate a spectral response of the tunable optical filter 18 from a spectral content of the input DUT signal. In a measurement stage, the processing circuitry 26 applies a changing control signal over a measurement range of values corresponding to a spectral region of interest to the tunable optical filter 18 to generate DUT measurement samples. The processing circuitry 26 applies the calibration function to the DUT measurement samples to separate a spectral transfer function response of the at least one tunable optical filter to the applied control signal from a DUT response to the applied control signal to ultimately extract one or more spectral characteristics from the DUT response for evaluation.

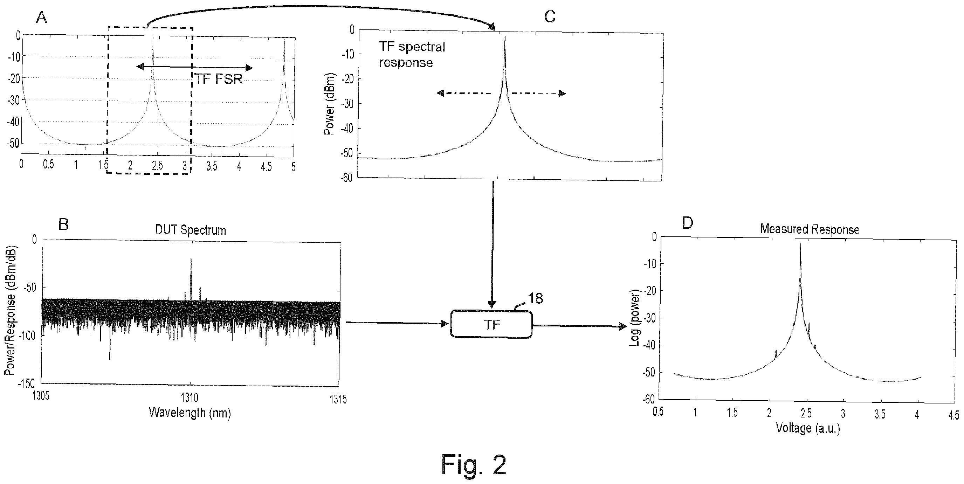

Figure 2 shows example spectral graphs A-D for the tunable optical filter 18 and DUT associated with the apparatus in the example embodiment of Figure 1. Graph A shows the transmission function and free spectral range FSR of the tunable optical filter 18. A vertical dashed rectangle identifies a transmission peak of the filter 18, which is separated from a next adjacent transmission peak by a wavelength difference corresponding to the tunable optical filter's free spectral response (FSR). For FP TFs, its resonant wavelengths and therefore its FSR depend on the FP TF's cavity length. As noted above, the FSR denotes how far apart in optical frequency (or wavelength) adjacent orders (resonant wavelengths) of a tunable filter are, which corresponds to the spacing of the transmitted (passed) peaks. A subset of the tunable optical filter's spectral response is shown in graph C. Applying the control signal from the processing circuitry 26 to the tunable optical filter 18 causes all transmission peaks of the tunable optical filter 18 to shift (either left or right) as it scans over a range of wavelengths. By tuning the optical filter 18, specific wavelengths of light can be selectively transmitted while others are attenuated or blocked. Graph B shows a DUT's spectrum over a wavelength range which in this example is from 1305 nanometers (nm) to 1315 nm. The DUT spectrum is input to the tunable filter 18, and the TF transmission spectrum, as determined by the control signal illustrated as coming from graph C, is used to scan or tune the tunable filter 18 over a range of control voltages corresponding to a range of different cavity sizes corresponding to a shifting transmission peak over wavelength. The output (the convolution of the signals in graph B and graph C) corresponds to a measured response for the DUT shown in graph D which includes a peak as well as several sidebands on both sides of the transmission peak, with the filter controller signal as the independent variable (shown in this example as voltage). The testing of the DUT for example aims to measure the magnitude and wavelength location of the sidebands (the smaller peaks shown in graph B on either side of the main peak) using the measured data from graph D, and knowledge about the TF spectral response in graph C.

When characterizing or using a Fabry-Perot filter, the measured spectral response might be affected by various factors such as imperfections in the optical surfaces, non-ideal behavior of the interference pattern, or external noise sources. These factors can introduce distortions or broaden the spectral features observed in the measured response. Calibrating a FP-TF is essential to ensure its accurate performance and reliable operation. Calibration involves determining the relationship between the tuning mechanism (such as a piezoelectric transducer) and the resulting optical response (e.g., transmission spectrum) of the FP-TF. In some example embodiments, the calibration includes determining a deconvolution vector which can be used in a measurement stage to separate a spectral response of the tunable optical filter 18 from a spectral content of the input DUT signal. A deconvolution vector deconvolves the measured spectral response to remove or mitigate the effects of the TF spectral response introduced during measurement, thereby obtaining a clearer representation of the DUT's input spectrum.

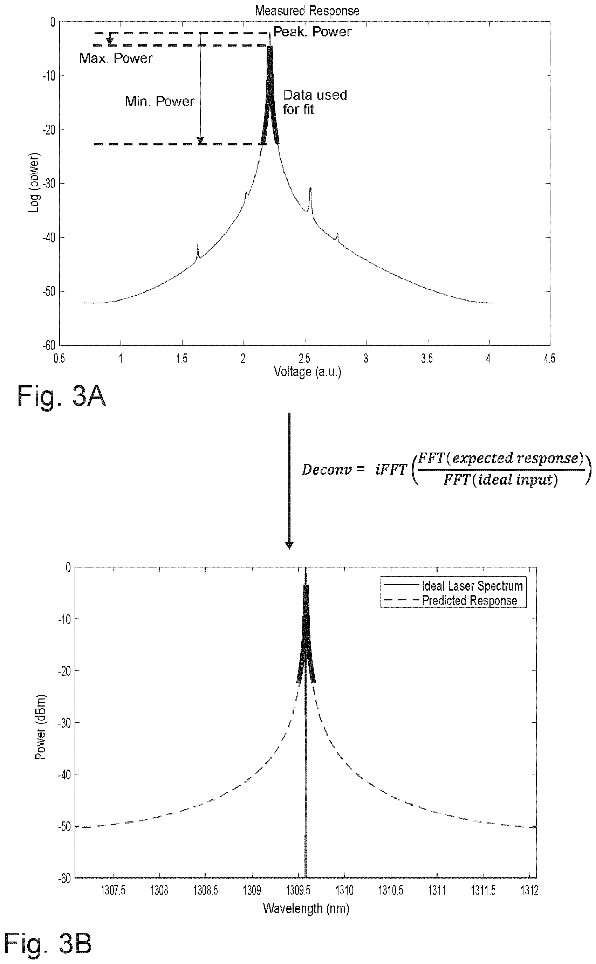

Figures 3A and 3B show example spectral graphs illustrating some aspects of generating a deconvolution vector for calibrating the measured DUT spectrum. Figure 3A shows a measured response spectrum of a nonideal hypothetical DUT after it has been passed through the TF. The bolded portion of the curve at the top is a region which is dominated by the response of the TF to the dominant (primary) wavelength of the DUT. Figure 3B shows the wavelength spectrum of a hypothetical, ideal DUT (solid line), and a resulting output that would be detected by the tunable filter if that ideal DUT signal were injected (dotted line). This process may begin, in an example implementation, by the processing circuitry 26 identifying a part of the tunable filter's measured DUT transmission spectrum around the peak as highlighted in bold in Figure 3A and then "fitting", i.e., comparing it to an ideal DUT spectrum in Figure 3B, or by analytic solution. Figure 3A illustrates selecting the part of the transmission peak that is between the maximum power point and a minimum power point as shown in bold.

This may be accomplished by the processing circuitry fitting a function to the portion of the data between a minimum and maximum amount of power, e.g., between 3dB and 20dB below the peak power. In linear units, that is between 50% and 1% of the peak power. This range is used because the primary signal of the DUT in that high power range will be completely dominated by the intended laser peak, so if side modes are present in that range they will not distort the resultant fit. The very peak of the response may optionally be omitted since it contains the highest frequency content of the waveform and may by clipped if the system bandwidth is insufficient. The fitted function may, for example, be a Lorentzian function. This function is used to determine the expected response from an idealized DUT input shown in Figure 3B over the range of voltages being swept (in logarithmic or linear units). The processing circuitry then calculates a deconvolution vector which reconstitutes that idealized form from the expected response as follows:

$$Deconv.\, vec. = \ iFFT\left(\frac{FFT(predicted\ response)}{FFT(ideal\ input)}\right)$$

The deconvolution vector is a collection of complex numbers so a graph of it is not shown. The above equation is one example way of generating a deconvolutional vector, but it can also be generated using other calculations.

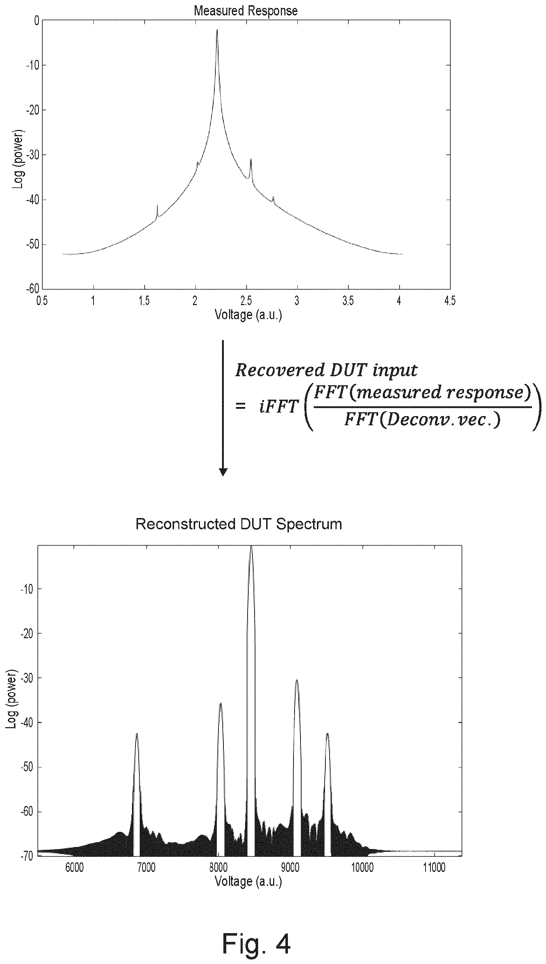

Figure 4 shows example spectral graphs for reconstructing the DUT spectrum using a deconvolution vector which occurs during the measurement stage. The filter's measured DUT response shown in the graph on the left includes a main peak and multiple side peaks which have had their power distributed into "tails" corresponding to the TF spectral response. As a result, the weaker side peaks are harder to resolve against the "shoulders" of the stronger main peak. The processing circuitry reconstructs the DUT input by applying the deconvolution vector to the filter's DUT measured response as follows:

$$Recovered\ DUT\ input = \ iFFT\left(\frac{FFT(measured\ response)}{FFT(Deconv.\, vec.)}\right)$$

The reconstructed DUT spectrum is shown in the right graph with a narrow main peak at the center wavelength and two sideband peaks at wavelengths on either side of the main peak. This is the reconstruction of the DUT signal which is shown in graph B of Figure 2.

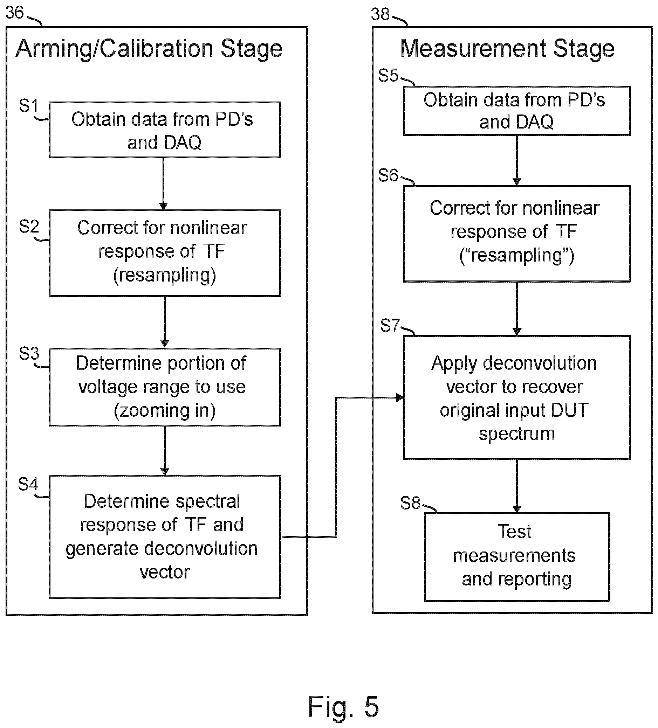

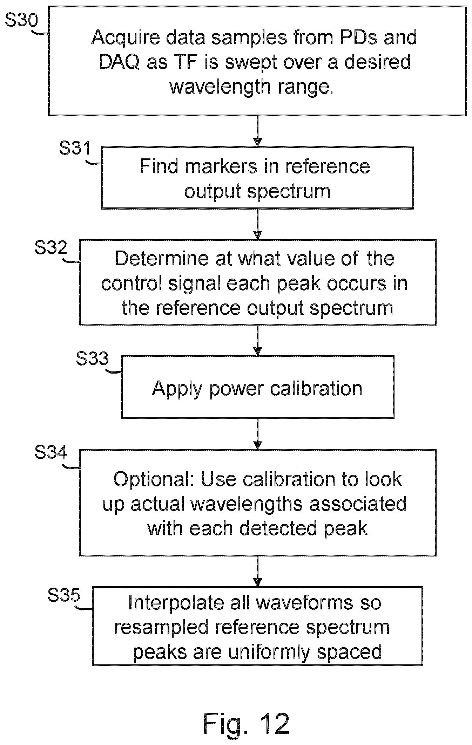

Figure 5 is a flowchart diagram showing example procedures performed by the processing circuitry 26 for both an arming/calibration process or sequence 36 and an example DUT spectrum measurement process and measurement sequence 38. In the arming/calibration process sequence 36, the output samples from each tunable filter are obtained from the PDs and DAQ in step S1. A nonlinear response for each tunable filter is corrected by resampling the output samples in step S2 (detailed in Figure 12). The zoom in range(s) of tuning control signals for the tunable filter(s) is(are) determined in step S3. The spectral response for the tunable filter is determined in step S4 and a corresponding deconvolution vector is generated. In the DUT spectrum measurement process or sequence 38, the output samples from the tunable filter are obtained from the PDs and DAQ in step S5. A nonlinear response for the tunable filter is corrected by resampling the output samples in step S6. The deconvolution vector generated in step S4 is applied to the resampled output to recover or reconstruct the original input DUT spectrum in step S7. In step S8, test measurements of the reconstructed DUT spectrum are performed, and the measurement results are reported.

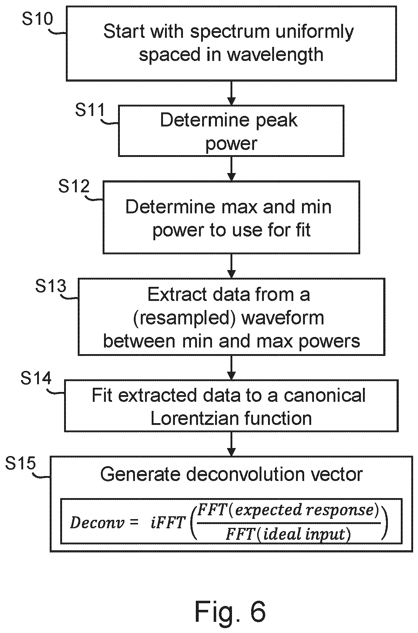

Figure 6 is a flowchart diagram showing example procedures for generating a deconvolution vector as part of the calibration stage (step S4). Step S10 starts assuming a tunable filter output spectrum that is uniformly spaced in wavelength, and that the amplitude of the output spectrum is proportional to the input power at each wavelength. This assumption may require a resampling process to correct for nonlinearities of the tunable filter as described in detail below. In steps S11 and S12, respectively, the processing circuitry 26 analyzes the tunable filter output spectrum to determine a peak power and then a maximum power and a minimum power to use for curve fitting as described above for Figure 3A. In step S13, the processing circuitry 26 extracts data from a waveform (which may well be a resampled waveform) between the maximum power and the minimum power (as shown in Figure 3A). In step S14, the processing circuitry 26 correlates or "fits" the extracted data to a particular function, e.g., a canonical Lorentzian function, and then in step S15, generates a deconvolution vector using the equation in the paragraph above.

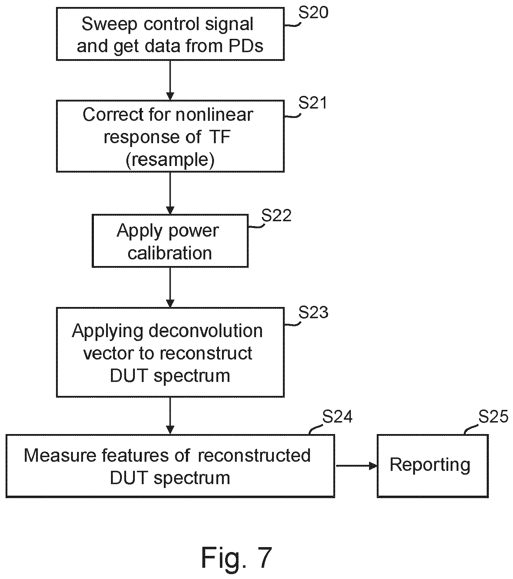

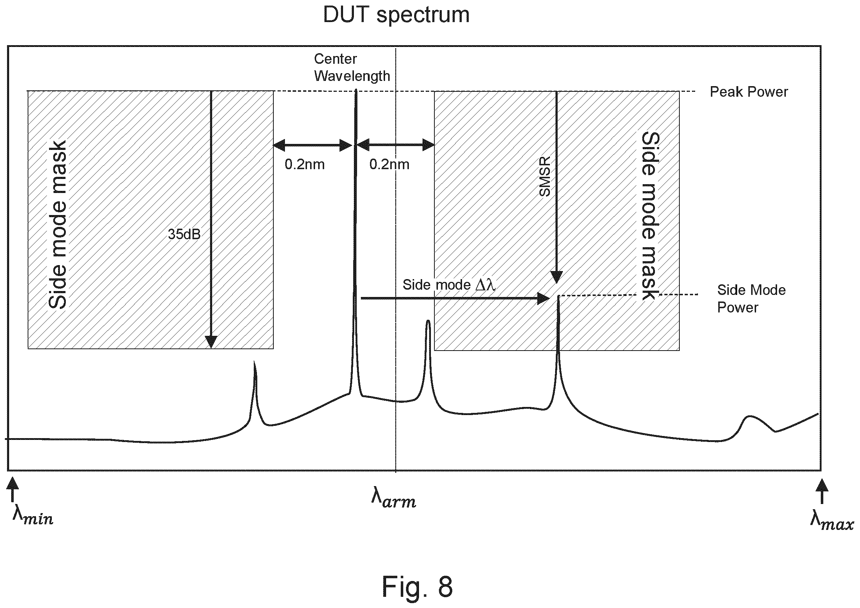

Figure 7 is a flowchart diagram showing example procedures for a DUT spectrum measurement process as a part of a measurement stage. In step S20, the processing circuitry 26 sweeps the tunable filter via the control signal through a predetermined spectrum, and the PDs 20 and 22 and data acquisition circuitry DAQ 24 provide DUT measurement samples to the processing circuitry 26. As described in detail below, the processing circuitry 26, in step S21, resamples the DUT measurement samples to correct for any nonlinear response of the tunable filter 18. In step S22, the processing circuitry 26 applies power calibration to the resampled DUT measurement samples. This power calibration may depend on the specific order of the tunable filter 18 which results in the measurement (described further below). In step S23, the processing circuitry 26 applies the deconvolution vector to reconstruct the DUT spectrum. In step S24, the processing circuitry 26 determines one or more parameters for the DUT, e.g., peak power, SMSR, etc. as shown in Figure 8, based on analysis of the reconstructed DUT spectrum an provides a report in step S25, e.g., as a data file, an output to a user interface, or other report.

Figure 8 shows an example of reconstructed DUT spectrum including a center wavelength and sidemodes. In addition, the processing circuitry may determine whether the reconstructed DUT spectrum satisfies one or more specified performance requirements based on the one or more extracted spectral characteristics. For example, the processing circuitry may determine the center wavelength and peak power of the main peak and apply a side mode mask to determine which sidemodes exceed the mask magnitude threshold, e.g., 35 dB relative to the peak power, including their respective powers and wavelengths, and determines side mode suppression ratio (SMSR), which is a measure of how much light a given laser is emitting at a wavelength other than the one at which the laser is designed to operate. A laser with insufficient SMSR emits light at a wavelength that is outside its allocated section of the spectrum, resulting in potential crosstalk with other channels that may occupy the same optical fiber. Other example test measurements for each laser include laser center wavelength which is the actual wavelength of the primary emission of the laser is emitting, total power emitted from the laser, side mode(s) wavelength(s) and power(s), and/or others. The testing results may be stored in a data file or communicated to user interface or another device.

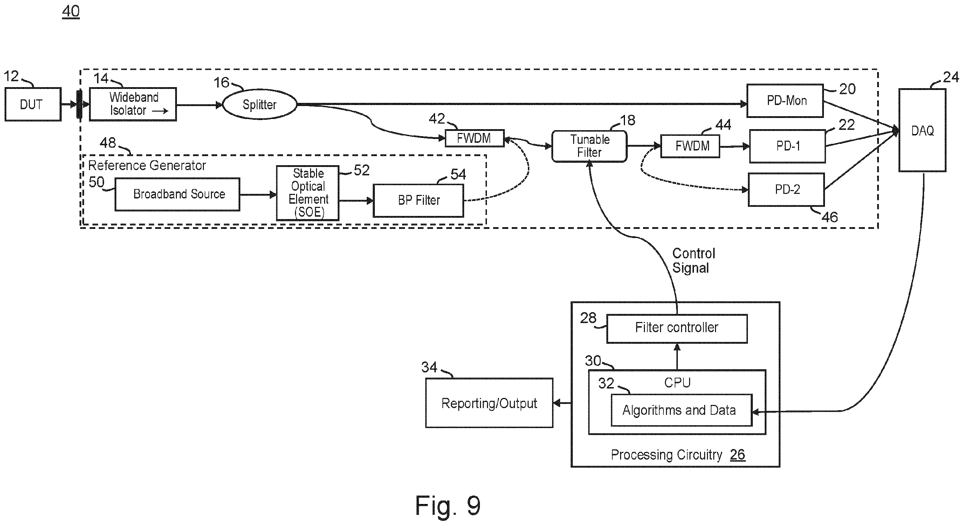

Figure 9 shows another example embodiment of a high-speed, self-calibrating spectrum testing apparatus 40 for measuring output spectral characteristics of a DUT. The apparatus 40 includes components similar to those in Figure 1 as indicated by common reference numerals and further includes a reference generator 48 for generating an input reference spectrum for characterizing the spectral transfer function of the tunable optical filter 18. In some embodiments, the reference generator 48 includes a broadband light source 50 that provides broadband light to a stable optical element (SOE) 52. The broadband light source 50 may for example include a semiconductor optical amplifier (SOA) coupled to an optical isolator. This combination of elements will produce a very broad ASE (amplified spontaneous emission) output (which can be more than 100nm wide). The SOE 52 may for example be an Athermal Fabry-Perot Interferometer (AFPI) or a gas cell that provides a modified broadband spectrum of light with known features at known wavelengths or at constant wavelength increments. The transmission function of the SOE preferably does not change over time, in which case it is desirable for it to be "athermal," i.e., the response does not change in response to temperature which is why an AFPI is indicated. However, other types of SOEs may be used if changes in response to external factors are accounted for. The output from SOE 52 is filtered by a bandpass filter 54, having a passband approximately corresponding to a width of the FSR of the tunable optical filter 18, to provide the reference spectrum to a fiber wavelength division multiplexer (FWDM) 42 that combines the reference light with the DUT light and delivers the combined light for input to the tunable filter 18.

The reference light is out of band or in a different wavelength band than the DUT light (as depicted in the figure by the use of dotted lines for refence light and solid lines for DUT light). For example, if the DUT is operating in the O-band (1260-1360nm), then the reference light may be selected to be in the S-band (1460-1530nm). As a result, when the filter output is provided to another FWDM 44, the FWDM 44 splits the light so that the reference light is detected by an additional optical detector, PD 46, and the DUT light is detected by PD 22. The PD signals are converted into DUT measurement samples and internal reference output samples by the data acquisition circuitry (DAQ) 24 and provided to the processing circuitry 26. As will be described further below, some of the DUT measurement samples and the reference output samples have nonuniform spectral spacing.

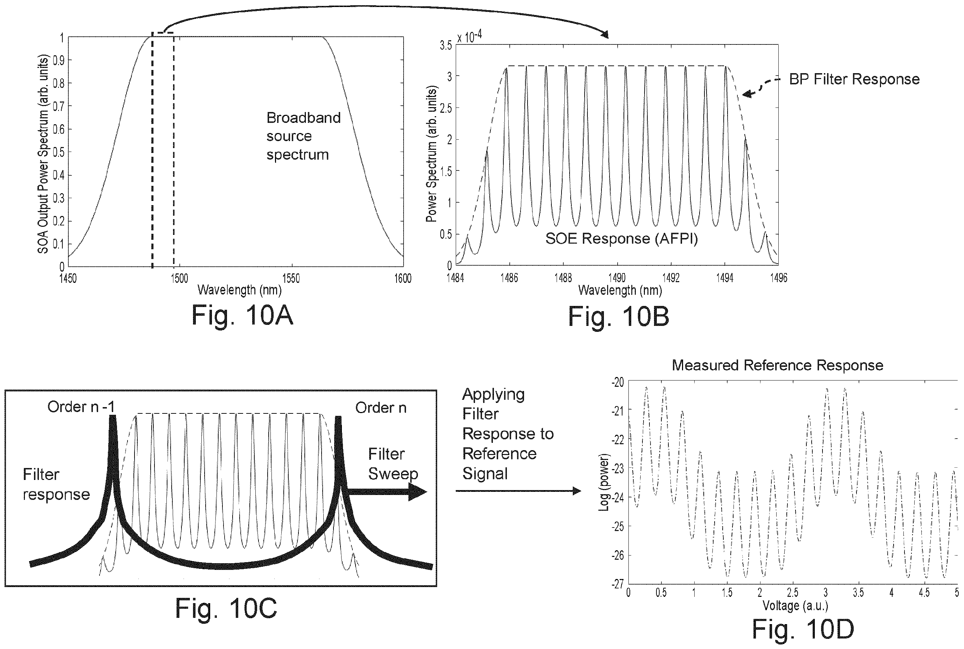

Figure 10A shows an example broadband source spectrum such as may be generated by the broadband source 50 spanning wavelengths roughly from 1450 nm to 1600 nm. Figure 10B shows an example spectral response output from the combination of a stable optical element 52 (solid) and the bandpass filter 54 (dashed) in Figure 8, where the passband approximate corresponds to a width of the FSR of the tunable optical filter 18 as shown in Figure 10C. The passband is approximately 1486 nm to 1494 nm in this example. Figure 10D is an example measured spectral response of the filter when it has been applied to the reference. The slowly varying oscillation shown in Figure 10D is the result of the number of orders of the TF response which overlap the reference spectrum for a given TF control signal. When two orders are overlapping part of the reference spectrum (as shown in Figure 10C), a higher total signal occurs. When only one order of the TF is within the range where there is power in the reference spectrum, a lower total power is detected. This variation may be used to aid in identifying the absolute wavelengths of the individual peaks within the larger waveform shown in Figure 10D.

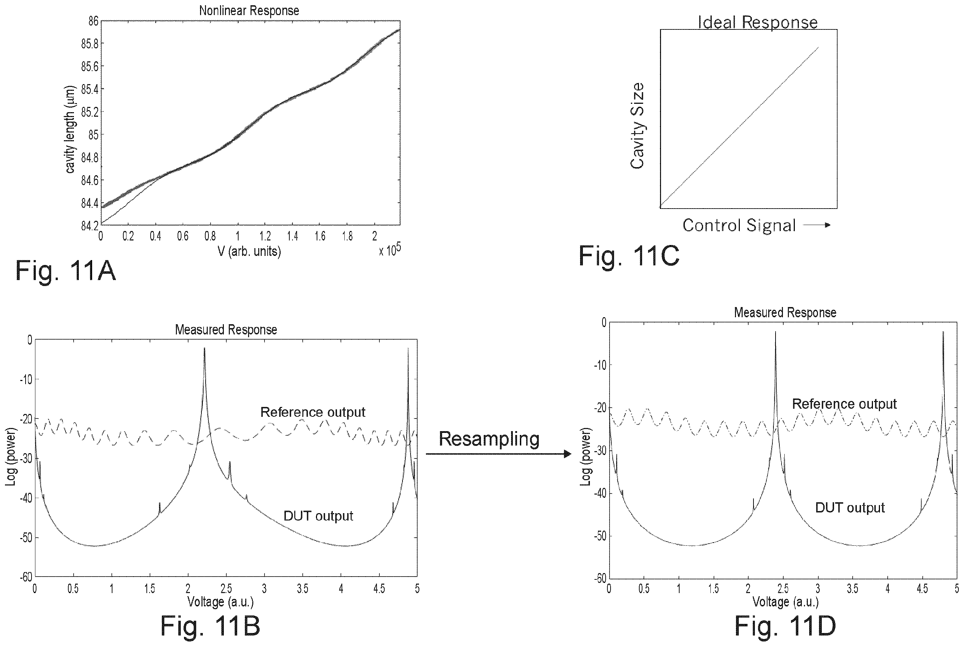

As mentioned above, FP-TFs may require calibration to compensate for nonlinearities and noise effects. Figures 11A and 11C show example graphs illustrating nonlinear and ideal responses for a tunable filter, respectively. Figure 11B shows how the impact of the nonlinear response can distort both the reference output and the DUT output as a function of the control signal. By detecting features ("markers") within the reference light that is transmitted by the TF 18, the processing circuitry can determine the exact instants in time at which the cavity of a FP TF has a specific size. Those features may be defined by the peaks or valleys of the detected reference output. Those time instants are used to resample the detected filter data so that the "markers" come at the correct intervals in the spectrum (Figure 11D). Applying that same resampling to the DUT data generates the spectrum that would have been produced had the response of the TF been perfectly linear.

The processing circuitry 28, in both the calibration and measurement stages, may process reference output samples having nonuniform spectral spacing to detect reference spectrum features. Based on the detected reference spectrum features, the processing circuitry 28 resamples the DUT measurement samples to uniform spacing in wavelength or optical frequency, thereby correcting for nonlinearity in one or more of: the spectral transfer function of the tunable optical filter 18, the control signal, and a response of the at least one tunable optical filter to the control signal. Figures 11B and 11D show example graphs of an example measured response of the tunable filter with both a DUT output and a reference output for the nonlinear and ideal cases, respectively. The reference output waveform in Figure 11B is non-uniform (varying frequency), whereas the reference output waveform after resampling is significantly more uniform as shown in Figure 11D.

Figure 12 is a flowchart diagram showing example resampling procedures that are used in example embodiments in the calibration stage and the measurement stage based on the measured reference spectrum from the reference generator 48. In step S30, the processing circuitry 26 acquires output spectrum data samples from the PDs 20, 22, 46 and DAQ 24 as the tunable filter 18 is swept over a desired wavelength range by tuning the control signal applied to the tunable filter 18. Those acquired output spectra include the DUT light and the reference light. In step S31, the processing circuitry 26 processes the data samples and determines markers in the reference spectrum. In step S32, the processing circuitry 26 determines the tuning control signal value that corresponds to each detected reference spectrum feature. In step S33, the processing circuitry 26 then applies a power calibration. This calibration may be specific to the absolute wavelengths embodied in the spectrum of the DUT. Optionally, in step S34, the processing circuitry 26 uses the calibration subset to look up actual wavelengths associated with each detected reference spectrum marker. In step S35, the processing circuitry 26 interpolates the DUT and reference spectrums to generate a resampled output for both the DUT and reference spectrums in which the reference spectrum peaks are uniformly spaced and in which the amplitude at all points in the output spectra share the same responsivity (i.e., equal amounts of input optical power result in equal measured outputs).

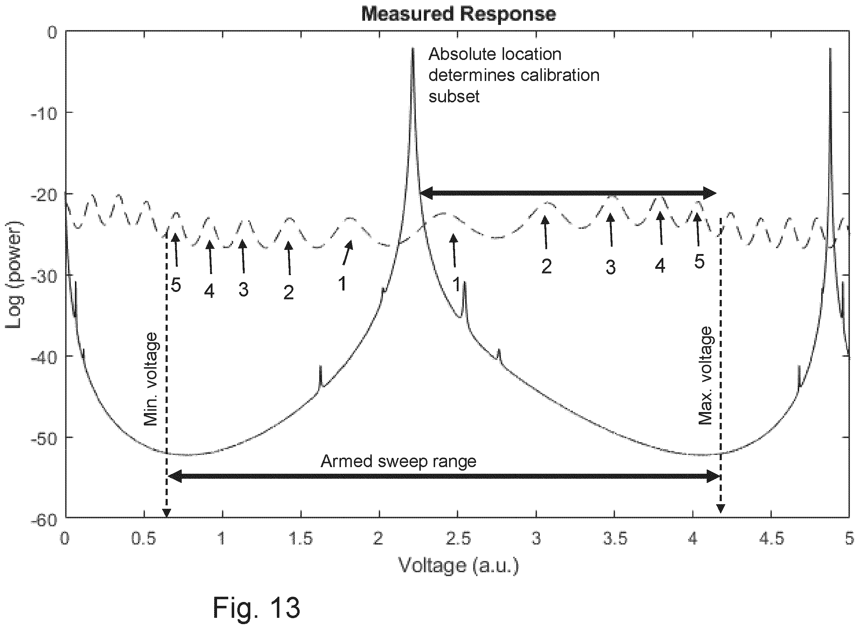

Figure 13 shows an example measurement response of the tunable filter 18 with the DUT and reference output spectrums illustrating selection of narrower tuning or "armed" sweep range for the tunable filter as part of the tunable filter calibration stage. This example measurement response of the tunable filter 18 is prior to the resampling procedure discussed above, as seen by the non-uniform intervals between the markers in the dashed reference spectrum. In the calibration stage, the processing circuitry 26 performs a zoom-in (or "focusing") of the range of control (tuning) signals applied to the tunable filter 18 to a wavelength region of interest. This zoom-in operation, combined with the generation of the deconvolution vector, is referred to as "arming" the apparatus. The absolute location of the main peak of the measured response allows a subset of control voltages for tuning the tunable filter 18 to be selected. In this particular example, the subset of control voltages is determined to be from five peaks of the reference signal before the main peak of the measured response to five peaks of the reference signal after the main peak of the measured response. To illustrate: if the known wavelength interval of the peaks in the reference signal (as mapped into the example DUT wavelength band) is 0.5nm, and the desired range of DUT measurement is +/- 2.5nm, then including five reference peaks on either side of the main peak ensures that any spectral content within the desired DUT measurement range is captured. That ten reference peak range is the armed sweep range in this example. Of course, other numbers of peaks of the reference signal before and/or after the main peak of the measured response may be used.

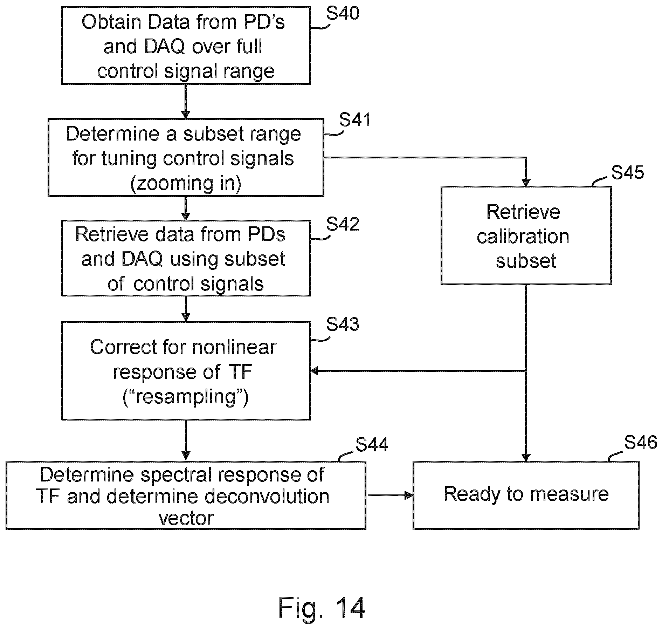

Figure 14 is a flowchart diagram showing example procedures for an example arming/calibration process for the apparatus in the example embodiment of Figure 13. In step S40, the processing circuitry 26 obtains calibration data samples from the PDs 20, 22 and the DAQ 24 over an initial, relatively large range of tuning control signals for the tunable filter 18 corresponding to a relatively large spectral range, and determines in step S41 a subset range for tuning control signals for the tunable filter 18, which can be understood as zooming in on the spectrum of interest. In step S42, the processing circuitry 26 obtains calibration data samples from the PDs 20, 22 and the DAQ 24 from the subset range (zoomed in portion) of tuning control signals. In step S45, the processing circuitry 26 retrieves the portion of the calibration data that corresponds to the zoomed in region for the specific order of the tunable filter 18, i.e., a calibration subset. In step S43, the processing circuitry 26 corrects for nonlinear response effects of the tunable filter 18 using the resampling technique described above. In step S44, the processing circuitry 26 determines a spectral response of the tunable filter 18 from that resampled output, from which a deconvolution vector is determined (see the example in Figure 6). At step 46, the system has all the information necessary to begin measurements, including the deconvolution vector generated in S44 and the calibration subset determined in S45.

In some instances, the desired resolution of the DUT spectrum may necessitate the use of a tunable filter which has a FSR which is smaller than the range of possible input DUT wavelengths. For example, if the possible range of DUT wavelengths corresponds to the entire O-band (1260nm - 1360nm) which has a width of 100nm (or equivalently 17.5THz), and the desired resolution of the measured spectrum requires an FSR of 1THz (-5.7nm), then there are 18 possible orders (17.5 rounded up to 18) of the tunable filter which may be in use, depending on the actual center wavelength of the DUT.

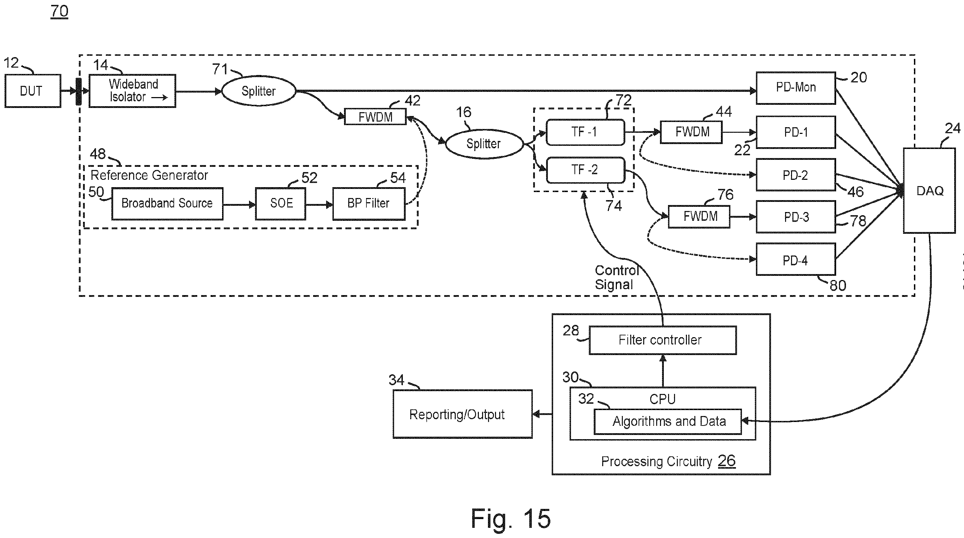

To address these instances, Figure 15 shows another example embodiment of a high-speed, self-calibrating spectrum testing apparatus 70 that uses two tunable optical filters 72 and 74 labeled TF-1 and TF-2 to make both a coarser spectral scan and a finer spectral scan of the DUT. For simplicity of explanation, it will be assumed in a non-limiting fashion that TF-2 74 ("coarse") has a larger FSR than TF-1 72 ("fine"). In an example embodiment, the coarse spectral scan may be generated by TF-2 74, which has an FSR of greater than 17.5 THz, and the fine spectral scan may be generated by TF-1 72, which has an FSR of 1THz. Because the FSR of TF-2 74 is greater than the entire range of possible DUT spectra (the O-band in this example), it provides a unique, relatively low-resolution transmission of the DUT signal for a DUT that occupies any wavelength within the O-band. That unique transmission serves to identify both the approximate absolute wavelength of the DUT, and correspondingly, which one of the 18 potential orders of that the finer TF-1 72 is actually transmitting the DUT input spectrum. Additionally, the identification of the specific order of the finer TF-1 72 can be used to identify a calibration subset which is applied to the DUT data during the resampling process.

The optical splitter 71 provides a portion of the light from the DUT 12 and the reference generator 48 to each of the tunable filters 72 and 74. The spectral response from the TF-1 72 is provided to the FWDM 44, which provides the DUT spectral response from the TF-1 72 to PD-1 22 and the reference spectral response to PD-2 46. The spectral responses from the TF-2 74 is provided to another FWDM 46 which provides the DUT spectral response from the TF-2 74 to PD-3 78 and the reference spectral response to the PD-4 80. The electrical signals from PD-1, PD-2, PD-3, and PD-4 are processed by DAQ 24 which provides corresponding samples to the processing circuitry 26.

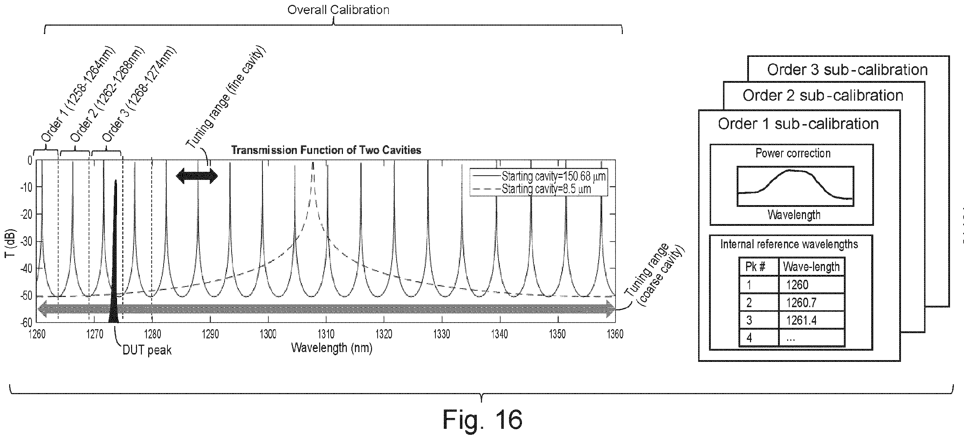

The graph in Figure 16 illustrates transmission functions of both a fine tunable filter (small FSR) and a coarse tunable filter (large FSR) on the same graph in one example implementation. The solid line shows the transmission function of the fine tunable filter, which has many orders of transmission across the O-band. The bold black double arrow shows an example of the range over which the fine tunable filter might be tuned (i.e., +/- one half of an FSR). When the fine tunable filter is adjusted, all the peaks in the transmission function will shift together. As illustrated in the graph, each section of the spectrum has a specific order which is responsible for passing wavelengths of light within that section, (e.g., light between 1262 and 1268nm will be transmitted only by order 2). The solid black peak in the graph represents one example of the DUT input spectrum. It falls in the region that is swept by order 3 of the fine tunable filter. Each order of the fine tunable filter may have a different calibration i.e., each order has its own calibration subset, which is a portion of the larger, overall calibration. This calibration may be specific to the absolute wavelengths contained in the spectrum of the DUT. This is advantageous in the event that the finesse of the tunable filter 18 (a measure of the difference between the highest and lowest amounts of transmission through a filter) is not uniform between all orders of the filter or varies as a function of the control signal. In this case, the power calibration in step S33, and wavelength identifications in step S34 will use the calibration subset which is on the appropriate page for that order of TF 18.

The dashed line shows the transmission function of the coarse tunable filter with its tuning range illustrated by the gray doubled ended arrow. Due to the mechanism by which some example tunable filters (FP-TF) are tuned, the same control signal will result in tuning over the same number of FSRs, independent of the value of the FSR. Therefore, a control signal that tunes the fine tunable filter over one FSR (6nm) will also tune the coarse tunable filter over its FSR (100nm in the example). Each individual order of the fine tunable filter may have its own calibration subset ("page"), which is retrieved in step S45 (from Figure 14). The right side of Figure 16 shows examples of calibration subsets which may be selected depending on which order of the fine tunable filter the DUT transmission peak occurs in as determined by using the coarse tunable filter.

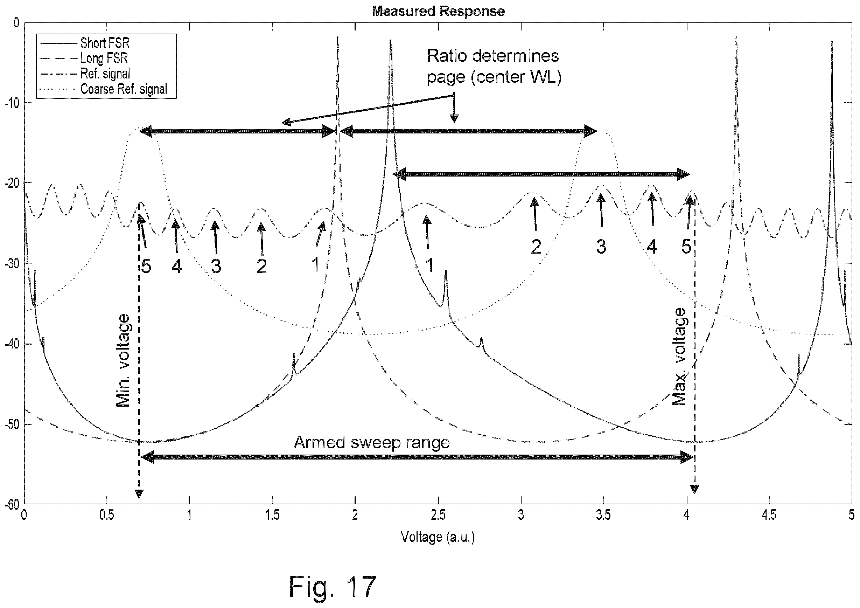

The graph in Figure 17 shows the entire sweep of the apparatus 70 when it is "disarmed." The location of the DUT peak (dashed line) from the coarse tunable filter 74 is compared to the locations of the peaks in the reference signal (fine dotted line) from the coarse tunable filter 74 to determine which order of the fine tunable filter 72 is to be used. The DUT peak from the fine tunable filter (solid line) is used as the starting point for determining the center of the voltage sweep once the apparatus is armed. The range of the control signal sweep to be used is determined by counting off the number of reference signal peaks from the fine tunable filter (dot-dashed line) corresponding to the maximum range of wavelengths that needs to be tested. In this example, the reference signal peaks are spaced such that each peak (which is in the S-band) correlates to a wavelength in the O-band which occur at 0.5nm increments, and the range of measurement of interest is up to 2.5nm on each side of the DUT wavelength at the time of arming. Therefore, the zoom-in control signal range includes five reference signal peaks to either side of the DUT peak when the arm command was issued and is labeled in Figure 17 as "Armed sweep range." This process corresponds to step S41. The apparatus 70 is now ready to proceed through the rest of the process shown in Figure 14 and then to the measurement stage for the DUT 12. Once apparatus 70 is armed, there is no need for further calibration with regard to any measurement test to be performed on this particular DUT 12. This provides for a significant increase in the speed at which each DUT can be tested because only one calibration/arming process is needed for all measurements for that DUT. Within this finer resolution, side modes can be measured, e.g., that exceed a predetermined power level.

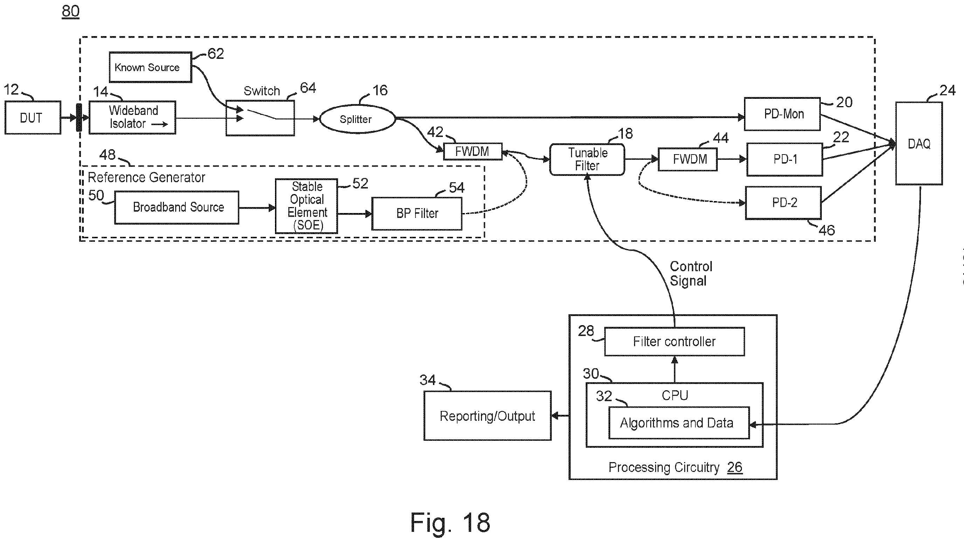

Figure 18 shows another example embodiment of a high-speed, self-calibrating spectrum testing apparatus 80 for measuring output spectral characteristics of a DUT. In this example embodiment, an optical switch 64 receives input light from the optical isolator 14 and from a known light source 62. This example embodiment is useful for cases where it is uncertain whether the DUT input spectrum meets the criteria for self-calibration (including generation of the deconvolution vector). For example, if the DUT spectrum has two peaks which are of substantially equal power, then the fitting of the data to a canonical Airy function will likely not be successful. In that circumstance, it is beneficial to have an internal, known, and reliable source to take the place of the DUT for the self-calibration procedure. Once that has been completed, the switch 64 can be switched to examine the DUT again.

EXAMPLE APPLICATIONS AND ADVANTAGES

Example applications for the technology described above include the rapid screening of many DUTs under many conditions. One example is for the quality control testing of semiconductor laser diodes. A semiconductor laser diode may include several parameters which are adjusted depending on the desired performance. One example is a device in which each laser can have a variable drive current, two heater currents, and a phase modulator voltage. If one assumes that there are only 10 possible settings for each of those parameters, that still represents 10,000 unique possible test conditions. A manufacturer of semiconductor laser diodes may produce hundreds of individual lasers on a single silicon wafer. Every one of those lasers needs to meet stringent specifications to avoid interfering (crosstalk) with other signals that may be on the same optical fiber.

Example advantages of the technology described above include the ability to test many DUTs at very high speed, without giving up either the ability to test over a large range of input wavelengths or the ability to achieve detection of high-resolution characterization of each DUT tested. A further advantage of the technology described is its suitability for assessing many DUTs in parallel. In one example implementation of the technology presented in this application, once the apparatus is in measurement mode, it can process DUT spectra at a rate of 100 spectra per second. In the example above, with 10,000 unique states to be tested as part of the DUT qualification process, the entire testing procedure would require 100 seconds. By contrast, a state-of-the-art "high speed" optical spectrum analyzer might be able to perform a 100nm sweep, with similar resolution, in 0.2 seconds (5 scans/ second). At that rate, the process of performing the same qualification would require more than 30 minutes. In applications where there may be hundreds of lasers on a single wafer to be tested, the high-speed throughput of the technology described here can reduce the time to qualify the wafer by a factor of 20. Another example advantage of the technology described here is the elimination of the need for external calibration sources (not requiring the input of a known spectrum) making the technology self-calibrating. A further advantage is that the high-speed spectrum testing technology continues to function properly in situations where optical characteristics of the testing apparatus change over time.

Although various embodiments have been shown and described in detail, the claims are not limited to any particular embodiment or example. None of the above description should be read as implying that any particular element, step, range, or function is essential. All structural and functional equivalents to the elements of the above-described embodiments that are known to those of ordinary skill in the art are expressly incorporated herein by reference and are intended to be encompassed. Features of the embodiments described above may be combined unless clearly technically impossible. Moreover, it is not necessary for a device or method to address each and every problem sought to be solved by the present invention, for it to be encompassed by the invention. No embodiment, feature, element, component, or step in this document is intended to be dedicated to the public.

All methods described herein can be performed in any suitable order unless otherwise indicated herein. The use of any and all examples, or example language (e.g., "such as") provided herein, is intended merely to better illuminate the example embodiments and does not pose a limitation on the scope of the claims appended hereto unless otherwise claimed.

The term "about" or "approximately" means an acceptable error for a particular recited value, which depends in part on how the value is measured or determined. In certain embodiments, "about" can mean 1 or more standard deviations. When the antecedent term "about" is applied to a recited range or value it denotes an approximation within the deviation in the range or value known or expected in the art from the measurement's method. For removal of doubt, it is understood that any range stated herein that does not specifically recite the term "about" before the range or before any value within the stated range inherently includes such term to encompass the approximation within the deviation noted above.

**Claims**

1. An apparatus for determining one or more spectral characteristics of an optical device under test (DUT), comprising:

   at least one tunable optical filter configured to receive an input DUT signal;
   data acquisition hardware to detect DUT output signals from the at least one tunable optical filter based on the input DUT signal;
   processing circuitry, coupled to the data acquisition hardware, configured to:

   apply a control signal over a calibration range of values to the at least one tunable optical filter to generate a calibration signal;
   use the calibration signal to determine a calibration function to separate a spectral response of the at least on tunable optical filter from a spectral content of the input DUT signal; and
   apply the control signal over a measurement range of values corresponding to a spectral region of interest to the at least one tunable optical filter to generate DUT measurement samples;
   apply the calibration function to the DUT measurement samples to separate a spectral transfer function of the at least one tunable optical filter from a DUT response to the applied control signal; and
   extract one or more spectral characteristics from the DUT response for evaluation.

2. The apparatus in claim 1, comprising:

   each tunable optical filter having a spectral transfer function that is adjustable based on a control signal and configured to receive a DUT input spectrum in a desired wavelength range and to output a DUT output spectrum corresponding to a modified version of the DUT input spectrum, the spectral transfer function having two or more peak transmission wavelengths with a spectral separation corresponding to a free spectral range (FSR) of the tunable optical filter;
   wherein the processing circuitry is configured, in a calibration stage, to:

   determine the calibration range of values; and
   apply the control signal over the calibration range of values to each tunable optical filter, where each tunable optical filter is configured to modify the DUT input spectrum to generate calibration samples,
   wherein the calibration function includes a deconvolution vector that is based on the calibration samples, and

   wherein the processing circuitry is configured, in a DUT measurement stage, to:

   apply the control signal over a range of values corresponding to a spectral region of interest to each tunable optical filter to generate DUT measurement samples;
   apply the deconvolution vector to the DUT measurement samples to generate the DUT response having a reconstructed DUT input spectrum; and
   extract one or more spectral characteristics from the reconstructed DUT spectrum for evaluation.

3. The apparatus in claims 1 or 2, wherein the DUT is a laser and the one or more spectral characteristics including one or more of the following: a side mode suppression ratio (SMSR), center wavelength power, peak width, one or more side mode wavelengths, and one or more sidemode powers.

4. The apparatus in any one of claims 1-3, wherein the processing circuitry is configured to determine whether the reconstructed DUT spectrum satisfies one or more specified performance requirements based on the one or more extracted spectral characteristics.

5. The apparatus in any one of claims 1-4, further comprising:

   an optical device to generate an input reference spectrum for characterizing a spectral transfer function of the at least one tunable optical filter, and
   optical detectors to detect light output from each tunable optical filter and to generate the DUT measurement samples and reference output samples which are provided to the processing circuitry,
   wherein at least some of the DUT measurement samples and the reference output samples have nonuniform spectral spacing, and
   wherein the processing circuitry, in at least one of the calibration stage and the DUT measurement stage, is configured to process the reference output samples having nonuniform spectral spacing to detect reference spectrum features, and based on the detected reference spectrum features, resample the DUT measurement samples to uniform spacing in wavelength or optical frequency thereby correcting for nonlinearity in one or more of: the spectral transfer function of the at least one tunable optical filter, the control signal, and a response of the at least one tunable optical filter to the control signal.

6. The apparatus in claim 5, wherein the input reference spectrum is in a wavelength band that is out of band from the wavelength band of operation of the DUT, the apparatus further comprising:

   a source with a broadband spectrum of light;
   an athermal optical device configured to receive the broadband spectrum of light and generate a modified broadband spectrum of light with known features at known wavelengths or at constant wavelength increments; and
   a bandpass filter, having a passband approximately corresponding to a width of the FSR of at least one tunable optical filter, configured to receive the modified broadband spectrum and provide the reference spectrum.

7. The apparatus in claim 5 or 6, wherein each tunable optical filter is a Fabry-Perot (FP) tunable optical filter operable based on interference and resonance within an optical cavity and the reference spectrum provides information of an instantaneous size of a cavity of the FP tunable optical filter, and wherein based on an associated time and cavity sizes for each reference spectral feature, the processing circuitry is configured to resample the DUT measurement samples to uniform spacing in wavelength or optical frequency so that the reference spectral features align in time with desired intervals in the spectrum.

8. The apparatus in any one of claims 5-7, wherein the processing circuitry is configured, in the calibration stage, to:

   apply the control signal over the range of values to each tunable optical filter to generate the reference spectrum;
   determine a location of a main spectral peak in the DUT measurement samples relative to the reference spectrum;
   determine a limited range of control signal values based on the location of the main spectral peak; and
   apply the control signal over the limited range of control signal values to determine a calibration range of values based on the location of the main spectral peak relative to the reference spectrum to correct for wavelength dependent variations in system responsivity.

9. The apparatus in claim 8, wherein the processing circuitry is configured, in a calibration stage, to:

   correlate the main spectral peak to an ideal spectral shape of an expected spectral transfer function of the at least one tunable optical filter and determine an expected response to an ideal DUT input spectrum; and
   generate a deconvolution vector based on the expected spectral transfer function of the at least one tunable optical filter and the ideal DUT input spectrum.

10. The apparatus in claim 9, further comprising:
    a known optical source having a known optical input spectrum and where the known optical source can be used as a DUT, wherein the processing circuitry is configured, in the calibration stage, to:

measure the DUT output spectrum of the known optical source,
correlate the DUT output spectrum of the known optical source to a known spectral shape of the known optical source; and
generate the deconvolution vector based on the DUT output spectrum and the known optical input spectrum.

11. The apparatus in claim 10, wherein the processing circuitry is configured, in the DUT measurement stage, to:

based on the known optical input spectrum, resample the DUT measurement samples to uniform spacing in wavelength or optical frequency to generate resampled DUT measurement samples, and
apply the deconvolution vector to the resampled DUT measurement samples to generate the DUT response to the applied control signal.

12. The apparatus in claim 11, wherein the processing circuitry is configured, in the DUT measurement stage, to:

determine a primary spectral peak in the reconstructed DUT input spectrum which corresponds to a DUT center wavelength, and
determine whether the one or more spectral characteristics fails to meet one or more predetermined parameters.

13. The apparatus in any of claims 1-12, further comprising a first tunable optical filter and a second tunable optical filter, wherein a first FSR of the first tunable optical filter is larger than a second FSR of the second tunable optical filter, wherein a location of a first main spectral peak of the first tunable optical filter and a location of a second main spectral peak of the second tunable optical filter are used to uniquely identify the one or more spectral characteristics of the DUT.

14. A method for determining one or more spectral characteristics of an optical device under test (DUT), comprising:

at least one tunable optical filter receiving an input DUT signal;
detecting DUT output signals from the at least one tunable optical filter based on the input DUT signal;
applying a control signal over a calibration range of values to the at least one tunable optical filter to generate a calibration signal;
using the calibration signal to determine a calibration function to separate a spectral response of the at least on tunable optical filter from a spectral content of the input DUT signal;
applying the control signal over a measurement range of values corresponding to a spectral region of interest to the at least one tunable optical filter to generate DUT measurement samples;
applying the calibration function to the DUT measurement samples to separate a spectral transfer function of the at least one tunable optical filter from a DUT response to the applied control signal; and
extracting one or more spectral characteristics from the DUT response for evaluation.

Fig. 1

Fig. 2

Fig. 3A

$$Deconv = iFFT \left( \frac{FFT(expected\ response)}{FFT(ideal\ input)} \right)$$

Fig. 3B

$$\text{Recovered DUT input} = iFFT\left(\frac{FFT(measured\ response)}{FFT(Deconv.\ vec.)}\right)$$

Fig. 4

**36** — Arming/Calibration Stage

S1 — Obtain data from PD's and DAQ

S2 — Correct for nonlinear response of TF (resampling)

S3 — Determine portion of voltage range to use (zooming in)

S4 — Determine spectral response of TF and generate deconvolution vector

**38** — Measurement Stage

S5 — Obtain data from PD's and DAQ

S6 — Correct for nonlinear response of TF ("resampling")

S7 — Apply deconvolution vector to recover original input DUT spectrum

S8 — Test measurements and reporting

Fig. 5

| S10 | Start with spectrum uniformly spaced in wavelength |
|---|---|

| S11 | Determine peak power |
|---|---|

| S12 | Determine max and min power to use for fit |
|---|---|

| S13 | Extract data from a (resampled) waveform between min and max powers |
|---|---|

| S14 | Fit extracted data to a canonical Lorentzian function |
|---|---|

| S15 | Generate deconvolution vector

$$Deconv = iFFT\left(\frac{FFT(expected\ response)}{FFT(ideal\ input)}\right)$$ |
|---|---|

Fig. 6

Sweep control signal
and get data from PDs    S20

↓

Correct for nonlinear
response of TF
(resample)    S21

↓

Apply power
calibration    S22

↓

Applying deconvolution
vector to reconstruct
DUT spectrum    S23

↓

Measure features of reconstructed
DUT spectrum    S24   →   Reporting    S25

# Fig. 7

Fig. 8

Fig. 9

Fig. 10A

Fig. 10B

Fig. 10C

Fig. 10D

Nonlinear Response

Fig. 11A

Ideal Response

Fig. 11C

Measured Response

Fig. 11B

Resampling →

Measured Response

Fig. 11D

S30 — Acquire data samples from PDs and DAQ as TF is swept over a desired wavelength range.

S31 — Find markers in reference output spectrum

S32 — Determine at what value of the control signal each peak occurs in the reference output spectrum

S33 — Apply power calibration

S34 — Optional: Use calibration to look up actual wavelengths associated with each detected peak

S35 — Interpolate all waveforms so resampled reference spectrum peaks are uniformly spaced

Fig. 12

Fig. 13

EP 4 675 869 A1

Obtain Data from PD's
and DAQ over full
control signal range — S40

Determine a subset range
for tuning control signals
(zooming in) — S41

Retrieve data from PDs
and DAQ using subset
of control signals — S42

Correct for nonlinear
response of TF
("resampling") — S43

Retrieve
calibration
subset — S45

Determine spectral response of
TF and determine deconvolution
vector — S44

Ready to measure — S46

Fig. 14

Fig. 15

Fig. 16

Fig. 17

Fig. 18

Europäisches
Patentamt
European
Patent Office
Office européen
des brevets

# EUROPEAN SEARCH REPORT

Application Number

EP 24 18 6605

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/138790 A1 (ANTILA JARKKO [FI] ET AL) 18 May 2017 (2017-05-18) <br> * figures 1-7 * <br> * paragraphs [0001], [0031], [0039], [0058], [0065], [0071] - [0075], [0078], [0081], [0082], [0084], [0093], [0096], [0097], [0113] - [0115] * <br> ----- | 1-14 | INV. <br> H01S5/00 <br> G01J3/26 <br> G01J3/28 <br><br> ADD. <br> G01J3/02 |
| A | US 2018/216995 A1 (QIAN KUN [CN] ET AL) 2 August 2018 (2018-08-02) <br> * figure 1 * <br> * paragraphs [0007], [0024] - [0029], [0039] * <br> ----- | 1-14 | |
| A | CN 117 651 905 A (HEWLETT PACKARD DEVELOPMENT CO) 5 March 2024 (2024-03-05) <br> * abstract; figures 1,2 * <br> * paragraph [0013] - paragraph [0021] * <br> ----- | 1-14 | |
| A | US 2017/167919 A1 (LEARMONTH TIMOTHY [US] ET AL) 15 June 2017 (2017-06-15) <br> * figures 1-5 * <br> * paragraphs [0034] - [0049] * <br> ----- | 1-14 | TECHNICAL FIELDS SEARCHED (IPC) <br><br> G01J <br> H01S |
| A | EP 3 904 847 A1 (SHENZHEN HYPERNANO OPTICS TECH CO LTD [CN]) 3 November 2021 (2021-11-03) <br> * paragraphs [0029] - [0038] * <br> * figures 1-4 * <br> ----- | 1-14 | |

The present search report has been drawn up for all claims

| Place of search | Date of completion of the search | Examiner |
|---|---|---|
| Munich | 17 December 2024 | Gangl, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 6605

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2024

| Patent document cited in search report | | | Publication date | Patent family member(s) | | | Publication date |
|---|---|---|---|---|---|---|---|
| US 2017138790 | A1 | | 18-05-2017 | CN | 106687781 | A | 17-05-2017 |
| | | | | EP | 3161436 | A1 | 03-05-2017 |
| | | | | US | 2017138790 | A1 | 18-05-2017 |
| | | | | WO | 2015197920 | A1 | 30-12-2015 |
| US 2018216995 | A1 | | 02-08-2018 | CN | 105115700 | A | 02-12-2015 |
| | | | | JP | 6491399 | B2 | 27-03-2019 |
| | | | | JP | 2018530761 | A | 18-10-2018 |
| | | | | US | 2018216995 | A1 | 02-08-2018 |
| | | | | WO | 2017016141 | A1 | 02-02-2017 |
| CN 117651905 | A | | 05-03-2024 | CN | 117651905 | A | 05-03-2024 |
| | | | | EP | 4359864 | A1 | 01-05-2024 |
| | | | | US | 2024329434 | A1 | 03-10-2024 |
| | | | | WO | 2022271153 | A1 | 29-12-2022 |
| US 2017167919 | A1 | | 15-06-2017 | US | 2017167919 | A1 | 15-06-2017 |
| | | | | WO | 2017106305 | A1 | 22-06-2017 |
| EP 3904847 | A1 | | 03-11-2021 | CN | 113396316 | A | 14-09-2021 |
| | | | | EP | 3904847 | A1 | 03-11-2021 |
| | | | | JP | 7215777 | B2 | 31-01-2023 |
| | | | | JP | 2022524361 | A | 02-05-2022 |
| | | | | KR | 20210124303 | A | 14-10-2021 |
| | | | | US | 2022099493 | A1 | 31-03-2022 |
| | | | | WO | 2021097634 | A1 | 27-05-2021 |

EPO FORM P0459

For more details about this annex : see Official Journal of the European Patent Office, No. 12/82